# EUROPÄISCHE PATENTSCHRIFT

(11) **EP 2 218 115 B1**
(45) Veröffentlichungstag und Bekanntmachung des Hinweises auf die Patenterteilung: **31.10.2018**
(21) Anmeldenummer: 08855324.3
(22) Anmeldetag: 26.11.2008
(51) Int. Cl.: H01L 33/58

(54) **BELEUCHTUNGSVORRICHTUNG**
ILLUMINATION DEVICE
DISPOSITIF D'ÉCLAIRAGE

(30) Priorität: 30.11.2007 DE 102007057671
(43) Veröffentlichungstag der Anmeldung: 18.08.2010
(73) Patentinhaber: OSRAM Opto Semiconductors GmbH, 93055 Regensburg (DE)
(72) Erfinder: WIRTH, Ralph, 93098 Mintraching - Auhof (DE)
(74) Vertreter: Epping - Hermann - Fischer
(86) Internationale Anmeldenummer: PCT/DE2008/001959
(87) Internationale Veröffentlichungsnummer: WO 2009/068007

(56) Entgegenhaltungen:
- WO-A-2006/035391
- GB-A- 2 427 754
- US-A1- 2005 236 628
- US-A1- 2006 145 172
- US-B1- 6 490 104

## Beschreibung

Die vorliegende Erfindung betrifft eine Beleuchtungsvorrichtung, die insbesondere für die Allgemeinbeleuchtung geeignet ist.

Bei der Allgemeinbeleuchtung ist häufig eine lateral homogene Verteilung der Strahlungsintensität auf einer Strahlungsaustrittsseite der Beleuchtungsvorrichtung erwünscht. Insbesondere die Strahlungsintensität pro Austrittsfläche soll strahlungsaustrittsseitig möglichst homogen verteilt sein.

Aufgrund der oftmals begrenzten räumlichen Ausdehnung der Strahlungsquelle, die sich aus einem oder mehreren Strahlung emittierenden Halbleiterchips zusammensetzen kann, ist das Erreichen einer homogenen Strahlungsintensitätsverteilung bei einer großflächigen Strahlungsaustrittsfläche, deren Fläche größer als die von der Strahlungsquelle lateral überdeckte Fläche ist, oftmals erschwert. Insbesondere können sich strahlungsaustrittsseitig Bereiche mit einer gegenüber den angrenzenden Bereichen erhöhten Strahlungsintensität, so genannte Hot Spots, bilden, die von den direkt mit der Strahlungsquelle beleuchteten Bereichen herrühren. Dies ist bei Anwendungen, die strahlungsaustrittsseitig eine gleichmäßige Strahlungsintensität erfordern, in der Regel unerwünscht.

Darüber hinaus kann bei der Allgemeinbeleuchtung ein begrenzter Abstrahlwinkel gewünscht sein, um Flächen scharf begrenzt beleuchten zu können. Bisher werden zur Strahlformung vorrangig optische Elemente wie Linsen verwendet, die exakt zur Strahlungsquelle justiert sein müssen und die Bauhöhe der Beleuchtungsvorrichtung entscheidend beeinflussen.

Druckschrift WO2006/035391 A1 offenbart eine Beleuchtungsvorrichtung umfassend ein chipfernes Winkelfilterelement, bei der von dem Halbleiterchip ausgesandte Strahlung auf das Winkelfilterelement auftrifft und innerhalb eines ersten Einfallswinkelbereichs stärker reflektiert wird als innerhalb eines zweiten Einfallswinkelbereichs und der erste Einfallswinkelbereich kleinere Einfallswinkel umfasst als der zweite Einfallswinkelbereich.

Eine zu lösende Aufgabe besteht vorliegend darin, eine Beleuchtungsvorrichtung mit kompaktem Aufbau anzugeben, die das Ausbilden einer homogenen Strahlungsintensitätsverteilung auf der Strahlungsaustrittsseite der Beleuchtungsvorrichtung in lateraler Richtung erleichtert.

Diese Aufgabe wird durch eine Beleuchtungsvorrichtung gemäß Patentanspruch 1 gelöst.

Vorteilhafte Weiterbildungen der Beleuchtungsvorrichtung sind in den abhängigen Ansprüchen angegeben.

Gemäß einer vorteilhaften Ausführungsform der Erfindung umfasst die Beleuchtungsvorrichtung ein Chipgehäuse mit mindestens einer Vertiefung, die durch eine reflektierende Innenfläche begrenzt ist, sowie mindestens einen Strahlung emittierenden Halbleiterchip mit einer Chipfläche, der in der Vertiefung angeordnet ist, und ein chipfernes Winkelfilterelement, das in das Chipgehäuse integriert ist und dem Halbleiterchip in einer Vorzugsrichtung nachgeordnet ist, wobei die reflektierende Innenfläche mindestens zehnmal so groß ist wie die Chipfläche.

Die Chipfläche setzt sich aus den Teilflächen des Halbleiterchips zusammen, auf welche Strahlung auftreffen kann. Insbesondere sind dies die Seitenflächen des Halbleiterchips sowie eine dem Winkelfilterelement zugewandte Oberfläche des Halbleiterchips. Weist der Halbleiterchip eine flächige Gestalt auf, das heißt wenn die Länge und die Breite wesentlich größer sind als die Höhe des Halbleiterchips, so wird die Chipfläche der Oberfläche gleich gesetzt. Bei mehreren Halbleiterchips ergibt sich die gesamte Chipfläche aus der Summe der Chipflächen der einzelnen Halbleiterchips.

Gemäß einer weiteren vorteilhaften Ausführungsform der Erfindung ist die reflektierende Innenfläche hundertmal größer als die Chipfläche.

Mit Vorteil ist bei einem Flächenverhältnis zwischen der reflektierenden Innenfläche und der Chipfläche, das größer als 10:1, insbesondere größer als 100:1 ist, die Wahrscheinlichkeit reduziert, dass Lichstrahlen die mittels des Winkelfilterelements in das Chipgehäuse zurückreflektiert werden, von dem Halbleiterchip absorbiert werden. Dies ist insofern vorteilhaft, als die Reflektivität des Halbleiterchips in der Regel nur zwischen 20% und 80% beträgt, während durch die reflektierende Innenfläche eine höhere Reflektivität erzielt werden kann. Vorzugsweise beträgt die Reflektivität der reflektierenden Innenfläche 90% oder mehr, bevorzugt 95% oder mehr, besonders bevorzugt 98% oder mehr. Mittels einer derartigen Reflektivität kann die Effizienz der Beleuchtungsvorrichtung vorteilhaft gesteigert werden, da im Chipgehäuse nur ein geringer Strahlungsanteil durch Absorption verloren geht.

Wie eingangs bereits beschrieben wurde, können auf der Strahlungsaustrittsseite Bereiche mit einer gegenüber den angrenzenden Bereichen erhöhten Strahlungsintensität auftreten oder es können sich bei mischfarbiger Strahlung Bereiche ausbilden, die im Vergleich zu angrenzenden Bereichen eine deutlich verschiedene spektrale Zusammensetzung aufweisen.

Um dem entgegenzuwirken und eine homogene Strahlungsintensitätsverteilung und/oder Farbverteilung auf der Strahlungsaustrittsseite zu erzielen, wird vorliegend das Winkelfilterelement eingesetzt.

Gemäß einer vorteilhaften Ausführungsform kann die von dem Halbleiterchip ausgesandte Strahlung, die auf das Winkelfilterelement auftrifft, innerhalb eines ersten Einfallswinkelbereichs stärker reflektiert werden als innerhalb eines zweiten Einfallswinkelbereichs, wobei der erste Einfallswinkelbereich kleinere Einfallswinkel umfasst als der zweite Einfallswinkelbereich. Diese Ausführungsform ist insbesondere im Falle einer indirekten, flächigen Beleuchtung geeignet.

Gemäß einer alternativen Ausführungsform wird die von dem Halbleiterchip ausgesandte Strahlung, die auf das Winkelfilterelement auftrifft, innerhalb des zweiten Einfallswinkelbereichs stärker reflektiert als innerhalb des ersten Einfallswinkelbereichs. Diese Ausführungsform ist insbesondere im Falle einer Spot-Beleuchtung geeignet.

Ferner kann das Winkelfilterelement in Abhängigkeit von den Strahlungeigenschaften der Strahlungsquelle und der gewünschten Abstrahlcharakteristik entweder die Strahlung innerhalb des ersten Einfallswinkelbereichs stärker reflektieren als die Strahlung innerhalb des zweiten Einfallswinkelbereichs oder umgekehrt.

Die am Winkelfilterelement reflektierten Lichtstrahlen werden in das Chipgehäuse zurückreflektiert, wo sie idealerweise solange umlaufen, bis sie mit einem unkritischen Einfallswinkel auf das Winkelfilterelement auftreffen und aus der Beleuchtungsvorrichtung auskoppeln können.

Weiterhin kann mittels des Winkelfilterelements vorzugsweise der Abstrahlwinkel der von der Beleuchtungsvorrichtung ausgesandten Gesamtstrahlung verkleinert werden. In dieser Hinsicht übernimmt das Winkelfilterelement die Funktion eines strahlformenden optischen Elements. Jedoch weist das Winkelfilterelement insbesondere eine geringere Tiefe als ein herkömmliches optisches Element auf, so dass die Bautiefe der Beleuchtungsvorrichtung vorteilhaft verringert ist.

Bei einer bevorzugten Variante der Beleuchtungsvorrichtung weist das Winkelfilterelement Strukturelemente auf. Die Strukturelemente können kegelartig, pyramidenartig, prismenartig oder gleich inversen CPCs ausgebildet sein. Die Strukturelemente können gleich groß, gleich geformt und regelmäßig angeordnet sein. Es ist jedoch auch möglich, dass die Strukturelemente unterschiedlich groß, unterschiedlich geformt und in unregelmäßigen Abständen angeordnet sind. Die Strukturelemente können Ausdehnungen von wenigen Mikrometern bis hin zu wenigen Zentimetern aufweisen. Im Extremfall kann das Winkelfilterelement nur ein Strukturelement aufweisen, das sich über die gesamte Strahlungsaustrittsebene der Beleuchtungsvorrichtung erstreckt.

Gemäß einer weiteren Ausführungsform ist das Winkelfilterelement ein dielektrischer Filter. Der dielektrische Filter weist zumindest zwei dielektrische Schichten mit unterschiedlichem Brechungsindex auf.

Für den dielektrischen Filter sind Silizium-haltige Materialien geeignet. Beispielsweise kann eine erste Schicht ein Siliziumoxid und eine zweite Schicht ein Siliziumnitrid enthalten. Ferner können auch Titan-haltige Materialien für den dielektrischen Filter verwendet werden. Beispielsweise kann eine erste Schicht ein Siliziumoxid und eine zweite Schicht ein Titanoxid enthalten. Insbesondere weisen die Schichten eine Schichtdicke von λ₀/4n auf, wobei λ₀ die Vakuum-Wellenlänge der zu reflektierenden Strahlung und n der Brechungsindex in der jeweiligen dielektrischen Schicht ist.

Nachfolgend wird die reflektierende Innenfläche näher beschrieben. Die reflektierende Innenfläche kann beispielsweise durch Aufbringen einer Reflektorschicht auf die Innenfläche des Chipgehäuses ausgebildet werden, zum Beispiel durch Aufdampfen einer Metallschicht, beispielsweise einer Aluminiumschicht, oder Aufbringen einer Metallfolie auf das Chipgehäuse. In diesem Fall muss das Chipgehäuse nicht aus einem reflektierenden Material hergestellt sein. Es kann beispielsweise ein Kunststoffmaterial und/oder ein Keramikmaterial enthalten.

Es ist ist jedoch auch denkbar, dass das Chipgehäuse aus einem reflektierenden Material gebildet ist. Beispielsweise kann das Chipgehäuse aus einem einzigen Metallteil, beispielsweise aus einem tiefgezogenen Aluminiumteil, gebildet sein. In diesem Fall muss auf der Innenfläche des Chipgehäuses keine Reflektorschicht vorgesehen werden, da die Reflektivität des Chipgehäuses bereits ausreicht.

Bei einer bevorzugten Weiterbildung ist die Innenfläche glatt, das heißt sie weist nur Rauhigkeitsstrukturen auf, die gegenüber der Wellenlänge λ klein sind. Dadurch kann spiegelnde Reflexion stattfinden, das heißt der Einfallswinkel eines auftreffenden Lichtstrahls und der Reflexionswinkel sind, bezogen auf das Einfallslot, gleich groß.

Es ist jedoch auch möglich, dass die Innenfläche Unebenheiten aufweist, die gegenüber der Wellenlänge λ groß sind. Insbesondere ist die Innenfläche mittels der Unebenheiten derart aufgeraut, dass sich schräg zueinander verlaufende glatte Teilflächen herausbilden, welche wie Spiegelflächen wirken. Insbesondere im Falle von mischfarbiger Strahlung ist diese Ausgestaltung vorteilhaft, weil hierdurch bei der Reflexion an der Innenfläche eine bessere Durchmischung verschiedener Farbanteile erzielt werden kann.

Die reflektierende Innenfläche kann mindestens eine Seitenfläche umfassen. Die Seitenfläche ist vorliegend schräg zu einer Hauptebene angeordnet, in welcher sich das Winkelfilterelement erstreckt. Vorzugsweise grenzt die Seitenfläche unmittelbar an das Winkelfilterelement an.

Gemäß einer vorteilhaften Variante der Beleuchtungsvorrichtung ist zumindest eine Seitenfläche konkav gekrümmt. Mittels einer Krümmung der Seitenfläche kann die Reflexion im Chipgehäuse vorteilhaft beeinflusst werden.

Ferner kann die Innenfläche eine Bodenfläche aufweisen, die parallel zu der Hauptebene des Winkelfilterelements angeordnet ist und damit schräg zu der Seitenfläche verläuft. Insbesondere weist die Beleuchtungsvorrichtung eine ebene Bodenfläche sowie mehrere ebene Seitenflächen auf, die an die Bodenfläche angrenzen.

Es ist von Vorteil, wenn sowohl die Seitenfläche als auch die Bodenfläche eine Reflektivität von 90% oder größer, bevorzugt von 95% oder größer, besonders bevorzugt von 98% oder größer, aufweisen.

Gemäß einer bevorzugten Ausgestaltung bildet das Winkelfilterelement eine Abdeckung für das Chipgehäuse. Das Winkelfilterelement kann auf dem Chipgehäuse aufliegen oder passgenau in der Vertiefung angeordnet sein. Hierbei kann das Winkelfilterelement den Halbleiterchip vor äußeren Einflüssen schützen. Sowohl durch die Anordnung des Winkelfilterelements auf dem Chipgehäuse als auch durch die Anordnung in der Vertiefung ist das Winkelfilterelement in das Chipgehäuse integriert.

Eine weitere Möglichkeit der Integration des Winkelfilterelements in das Chipgehäuse besteht darin, die Seitenwand des Chipgehäuses aus demselben Material wie das Winkelfilterelement herzustellen. In diesem Fall können die Seitenwand und das Winkelfilterelement als ein einteiliger, selbsttragender Aufsatz hergestellt werden, welcher über den Halbleiterchip gestülpt wird. Vorzugsweise wird der Aufsatz auf einer Bodenplatte angeordnet, auf welcher auch der Halbleiterchip montiert wird. Beispielsweise kann der Aufsatz ein Kunststoffmaterial enthalten und mittels Spritzguss hergestellt sein.

Bei einer vorteilhaften Variante kann die Beleuchtungsvorrichtung eine Mehrzahl von Halbleiterchips aufweisen, die im Chipgehäuse nebeneinander angeordnet sind und Strahlung mit der gleichen Wellenlänge emittieren. Zur Erzeugung von mischfarbiger Strahlung kann den Halbleiterchips in der Vorzugsrichtung ein Konversionselement nachgeordnet sein, das einen ersten Strahlungsanteil der von dem Halbleiterchip erzeugten Stahlung unverändert durchlässt, so dass der unveränderte Strahlungsanteil eine kürzere Wellenlänge aufweist, und das einen zweiten Strahlungsanteil umwandelt, so dass der umgewandelte Strahlungsanteil eine längere Wellenlänge aufweist. Das Konversionselement kann chipnah angeordnet sein, so dass das Konversionselement direkt an den Halbleiterchip angrenzt. Alternativ kann das Konversionselement chipfern angeordnet sein, so dass das Konversionselement nicht direkt an den Halbleiterchip angrenzt.

Bei einer weiteren vorteilhaften Variante weist die Beleuchtungsvorrichtung eine Mehrzahl von Halbleiterchips auf, die im Chipgehäuse nebeneinander angeordnet sind und Strahlung mit unterschiedlicher Wellenlänge emittieren. Insbesondere weist die Beleuchtungsvorrichtung in regelmäßiger Abfolge einen rot emittierenden Halbleiterchip, einen grün emittierenden Halbleiterchip und einen blau emittierenden Halbleiterchip auf.

Weitere Merkmale, Vorteile und Weiterbildungen der Erfindung ergeben sich aus den nachfolgend in Verbindung mit den Figuren 1 bis 7 erläuterten Ausführungsbeispielen.

Es zeigen:
Figur 1 eine schematische Querschnittsansicht eines ersten Ausführungsbeispiels einer erfindungsgemäßen Beleuchtungsvorrichtung,
Figur 2 eine schematische Querschnittsansicht eines zweiten Ausführungsbeispiels einer erfindungsgemäßen Beleuchtungsvorrichtung,
Figur 3 eine schematische Querschnittsansicht eines dritten Ausführungsbeispiels einer erfindungsgemäßen Beleuchtungsvorrichtung,
Figur 4A eine schematische Aufsicht und Figur 4B eine schematische Querschnittsansicht eines vierten Ausführungsbeispiels einer erfindungsgemäßen Beleuchtungsvorrichtung,
Figur 5 ein Schaubild darstellend die reflektivitätsabhängige Extraktionseffizienz einer erfindungsgemäßen Beleuchtungsvorrichtung,
Figur 6 eine Abbildung darstellend die Strahlungsintensitätsverteilung eines Lambertstrahlers,
Figur 7 eine Abbildung darstellend die Strahlungsintensitätsverteilung einer erfindungsgemäßen Beleuchtungsvorrichtung.

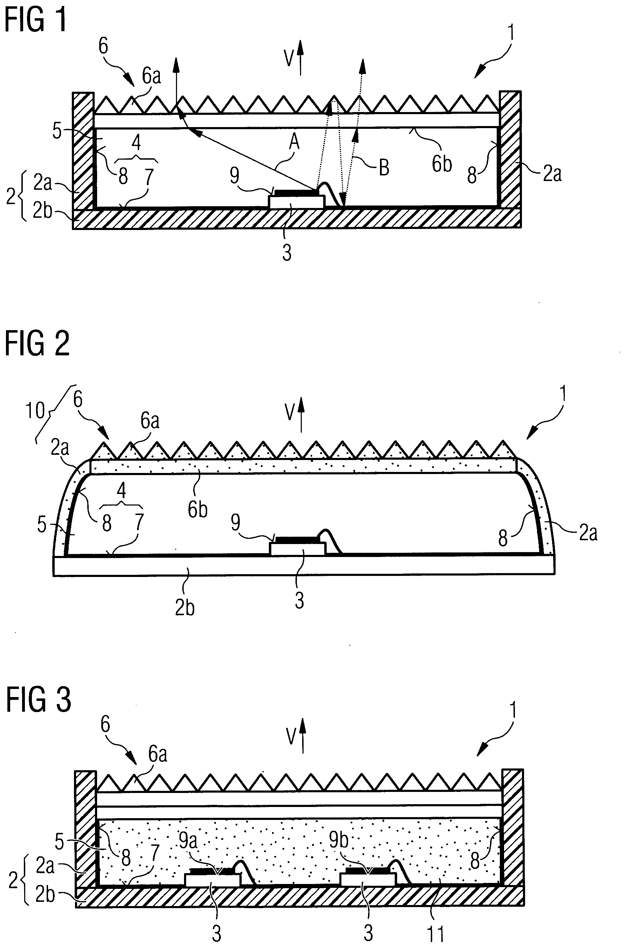

Die in Figur 1 dargestellte Beleuchtungsvorrichtung 1 weist ein Chipgehäuse 2 auf, in welchem ein Strahlung emittierender Halbleiterchip 3 angeordnet ist. In das Chipgehäuse 2 ist ein chipfernes Winkelfilterelement 6 integriert, das dem Strahlung emittierenden Halbleiterchip 3 in einer Vorzugsrichtung V nachgeordnet ist.

Vorliegend gibt die Vorzugsrichtung V die Richtung an, in welche ein Großteil der von der Beleuchtungsvorrichtung 1 abgegebenen Strahlung ausgesandt wird.

Der Strahlung emittierende Halbleiterchip 3 ist in einer Vertiefung 5 des Chipgehäuses 2 angeordnet. Die Vertiefung 5 wird durch eine Innenfläche 4 begrenzt, die eine Bodenfläche 7 und mehrere Seitenflächen 8 umfasst. Die Seitenflächen 8 sowie die Bodenfläche 7 sind eben, wobei die Seitenflächen 8 senkrecht zur Bodenfläche 7 verlaufen. Da die Länge des Chipgehäuses 2 wesentlich größer ist als die Höhe, weist das Chipgehäuse 2 eine flächige Gestalt auf.

Das Chipgehäuse 2 umfasst eine Bodenplatte 2b mit der Bodenfläche 7 und Seitenwände 2a mit den Seitenflächen 8. Die Bodenplatte 2b kann beispielsweise ein Keramikmaterial enthalten, insbesondere ein Material mit hoher thermischer Leitfähigkeit, um den Strahlung emittierenden Halbleiterchip 3 im Betrieb ausreichend zu kühlen. Ferner ist für die Seitenwände 2a ein Kunststoffmaterial geeignet.

Beispielsweise kann die Innenseite des Chipgehäuses 2 verspiegelt sein, so dass die Innenfläche 4 reflektierend ist. Vorzugsweise beträgt die Reflektivität der reflektierenden Innenfläche 4 90% oder mehr, bevorzugt 95% oder mehr, besonders bevorzugt 98% oder mehr. Mittels einer derartigen Reflektivität kann die Effizienz der Beleuchtungsvorrichtung 1 vorteilhaft gesteigert werden, da im Chipgehäuse 2 nur ein geringer Strahlungsanteil durch Absorption verloren geht.

Die Innenfläche 4 und eine Chipfläche 9 des Halbleiterchips 3, wobei die Chipfläche 9 in diesem Fall eine dem Winkelfilterelement 6 zugewandte Oberfläche des Halbleiterchips 3 ist, sind relativ zueinander in einer Weise dimensioniert, dass Reflexionen im Chipgehäuse 2 hauptsächlich an der Innenfläche 4 stattfinden. Vorzugsweise ist die Innenfläche 4 mindestens zehnmal so groß wie die Chipfläche 9. Besonders bevorzugt ist die Innenfläche 4 hundertmal größer als die Chipfläche 9. Beispielsweise kann die Innenfläche 4 1cm² und und die Chipfläche 9 1mm² groß sein.

Das Winkelfilterelement 6 weist eine Mehrzahl von pyramidenförmigen Strukturelementen 6a mit geneigten Seitenflächen auf. Bei dem dargestellten Ausführungsbeispiel ist der Winkel zwischen den geneigten Seitenflächen bei allen Strukturelementen 6a gleich groß. Im Rahmen der Erfindung sind Winkel bevorzugt, die zwischen 70° und 110° liegen. Es ist auch denkbar, dass verschiedene Winkel zwischen den geneigten Seitenflächen verwendet werden. Hierdurch können auf einer beleuchteten Fläche Konturen der Strukturelementen 6a unterdrückt werden. Ferner kann eine Musterbildung dadurch verhindert werden, dass nicht-rotationssymmetrische Strukturelemente 6a gegeneinander verdreht werden und/oder unterschiedlich geformt werden und/oder unregelmäßig angeordnet werden.

Bei dem Ausführungsbeispiel der Figur 1 sind die Strukturelemente 6a auf einer dem Halbleiterchip 3 abgewandten Oberfläche des Winkelfilterelements 6 angeordnet, wobei sich die Strukturelemente 6a in Vorzugsrichtung V verjüngen.

Eine dem Halbleiterchip 3 zugewandte Oberfläche 6b des Winkelfilterelements 6 ist eben ausgebildet. Die Oberfläche 6b befindet sich in einer Hauptebene des Winkelfilterelements 6. Die Hauptebene ist parallel zu einer Strahlungsaustrittsebene der Beluchtungsvorrichtung 1 und senkrecht zur Vorzugsrichtung V angeordnet.

Das Winkelfilterelement 6 kann beispielsweise ein Spritzgussteil sein oder aus einem Trägerplättchen hergestellt werden, auf das eine Lackschicht aufgebracht wird, aus welcher die Strukturelemente 6a herausgebildet werden.

Ein Teil der von dem Halbleiterchip 3 emittierten Strahlung kann zunächst auf das Winkelfilterelement 6 auftreffen. Dort wird ein erster Strahlungsanteil durch das Winkelfilterelement 6 transmittiert, während ein zweiter Strahlungsanteil in das Chipgehäuse 2 zurückreflektiert wird.

Mittels des Winkelfilterelements 6 können bei dem vorliegenden Ausführungsbeispiel die Lichstrahlen, die mit einem Einfallswinkel, der innerhalb des zweiten Einfallswinkelbereichs liegt, also Lichtstrahlen mit relativ großem Einfallswinkel durch das Winkelfilterelement 6 transmittiert werden. Dies wird in der Figur 1 durch den Lichtstrahl A verdeutlicht.

Der Lichtstrahl A trifft auf die Oberfläche 6b des Winkelfilterelements 6 auf und wird zum Einfallslot "hingebrochen", wobei der Einfallswinkel größer ist als der Ausfallswinkel. Der Lichtstrahl A passiert das Winkelfilterelement 6 und trifft unter einem unkritischen Winkel auf die geneigte Seitenfläche des Strukturelements 6a auf, so dass der Lichtstrahl A aus dem Winkelfilterelement 6 auskoppeln kann. Beim Austritt aus dem Winkelfilterelement 6 wird der Lichtstrahl A vom Einfallslot "weggebrochen" und infolgedessen in die Vorzugsrichtung V umgelenkt.

Lichstrahlen, die mit einem Einfallswinkel, der innerhalb des ersten Einfallswinkelbereichs liegt, also Lichtstrahlen mit relativ kleinem Einfallswinkel können bei dem vorliegenden Ausführungsbeispiel durch das Winkelfilterelement 6 reflektiert werden. Dies wird in der Figur 1 durch den Lichtstrahl B verdeutlicht.

Der Lichtstrahl B trifft im Wesentlichen parallel zur Vorzugsrichtung V auf die Oberfläche 6b des Winkelfilterelements 6 auf und wird daher kaum abgelenkt. An einer der geneigten Seitenflächen des Strukturelements 6a wird der Lichtstrahl B totalreflektiert und trifft auf die gegenüber liegende Seitenfläche des Strukturelements 6a auf. Hier wird der Lichtstrahl B erneut totalreflektiert. Nach der Reflexion gelangt der Lichtstrahl B wieder in das Chipgehäuse 2 und wird dort, insbesondere an der Innenfläche 4, solange reflektiert bis der Lichtstrahl B unter einem unkritischen Winkel auf das Winkelfilterelement 6 auftrifft und auskoppeln kann. Der Lichtstrahl B weist dann eine Richtung auf, die wenig von der Vorzugsrichtung V abweicht.

Die von der Beleuchtungsvorrichtung 1 emittierte Strahlung kann mittels des Winkelfilterelements 6 vorteilhaft durchmischt weden, das heißt, dass in einem beliebigen Bereich einer Strahlungsaustittsebene der Beleuchtungsvorrichtung 1 Lichtstrahlen des ersten und des zweiten Winkelbereichs gleichermaßen vorhanden sind. Hierbei erstreckt sich die Strahlungsaustittsebene senkrecht zur Vorzugsrichtung V.

Ferner kann mittels des vorliegenden Winkelfilterelements 6 eine Strahlformung der von der Beleuchtungsvorrichtung 1 emittierten Strahlung bewirkt werden. Insbesondere wird mittels des Winkelfilterelements 6 der Abstrahlwinkel eingeschränkt.

Vorzugsweise enthält der Strahlung emittierende Halbleiterchip 3 bei dem Ausführungsbeispiel der Figur 1 einen Nitridverbindungshalbleiter und ist ein Dünnfilm-Halbleiterchip. Bei der Herstellung des Dünnfilm-Halbleiterchips 3 wird eine Halbleiterschichtenfolge, die eine Strahlung emittierende aktive Schicht umfasst, zunächst epitaktisch auf einem Aufwachssubstrat aufgewachsen. Dann wird ein Träger auf eine dem Aufwachssubstrat gegenüber liegende Oberfläche der Halbleiterschichtenfolge aufgebracht und nachfolgend das Aufwachssubstrat abgetrennt. Da insbesondere die für Nitridverbindungshalbleiter verwendeten Aufwachssubstrate, beispielsweise SiC, Saphir oder GaN vergleichsweise teuer sind, bietet dieses Verfahren insbesondere den Vorteil, dass das Aufwachssubstrat wiederverwertbar ist.

Ein Grundprinzip einer Dünnfilm-LED ist beispielsweise in I. Schnitzer et al., Appl. Phys. Lett. 63 (16), 18. Oktober 1993, 2174 - 2176 beschrieben.

Der Dünnfilm-Halbleiterchip ist ein Lambertstrahler mit vorteilhafter Auskoppeleffizienz.

Das Winkelfilterelement 6 ist in das Chipgehäuse 2 passgenau eingebracht und deckt die Vertiefung 5 des Chipgehäuses 2 ab. Somit kann der Strahlung emittierende Halbleiterchip 3 vor äußeren Einflüssen wie Feuchtigkeit, Staub oder anderen Fremdkörpern geschützt werden.

Ein zwischen dem Strahlung emittierenden Halbleiterchip 3 und dem Winkelfilterelement 6 ausgebildeter Hohlraum ist bei diesem Ausführungsbeispiel mit Luft gefüllt. Hierdurch kann ein vorteilhaft hoher Brechungsindexsprung am Übergang zwischen dem Hohlraum und dem Winkelfilterelement 6 erzielt werden.

Die in Figur 2 dargestellte Beleuchtungsvorrichtung 1 weist einen ähnlichen Aufbau wie die Beleuchtungsvorrichtung der Figur 1 auf. Allerdings sind bei dem Ausführungsbeispiel der Figur 2 die Seitenwände 2a und das Winkelfilterelement 6 einteilig ausgebildet. Insbesondere ist der so gebildete selbsttragende Aufsatz 10 ein Spritzgussteil. Der Aufsatz 10 ist über den Halbleiterchip 3 gestülpt und auf der Bodenplatte 2b angeordnet.

Die Seitenwände 2a können mit einer Reflektorschicht versehen werden, bevor der Aufsatz 10 auf der Bodenplatte 2b angeordnet wird, so dass infolge die Seitenfläche 8 reflektierend ist.

Um mischfarbige Strahlung zu erzeugen, kann sowohl dem in Figur 1 dargestellten Halbleiterchip 3 als auch dem in Figur 2 dargestellten Halbleiterchip 3 ein Konversionselement nachgeordnet sein. Dies kann unmittelbar an den Halbleiterchip 3 angrenzen oder beabstandet zum Halbleiterchip 3 angeordnet sein. Ferner können die in den Figuren 1 und 2 gezeigten Beleuchtungsvorrichtungen auch mehrere Halbleiterchips aufweisen, die Strahlung mit der gleichen Wellenlänge erzeugen und denen gegebenenfalls ein Konversionselement nachgeordnet ist.

Figur 3 zeigt eine Beleuchtungsvorrichtung 1, die mehrere Strahlung emittierende Halbleiterchips 3 aufweist. Die Strahlung emittierenden Halbleiterchips 3 sind auf der Bodenplatte 2b nebeneinander angeordnet.

Bei diesem Ausführungsbeispiel setzt sich die gesamte Chipfläche aus einer Summe der einzelnen Chipflächen 9a und 9b zusammen. Für das Flächenverhältnis gilt, dass die reflektierende Innenfläche 4 mindestens zehnmal so groß, vorzugsweise hundertmal größer ist als die Summe der einzelnen Chipflächen 9a und 9b.

Die Strahlung emittierenden Halbleiterchips 3 erzeugen Strahlung mit verschiedenen Wellenlängen. Vorzugsweise weist die Beleuchtungsvorrichtung 1 mindestens einen Halbleiterchip auf, der rotes Licht erzeugt, einen, der blaues Licht erzeugt, und einen, der grünes Licht erzeugt, so dass von der Beleuchtungsvorrichtung 1 insgesamt weißes Licht emittiert wird.

Mittels des Winkelfilterelements 6 kann die verschieden farbige Strahlung in der Strahlungsaustrittsebene vorteilhaft durchmischt werden, so dass keine verschieden farbigen Lichtflecke auftreten.

Die Vertiefung 5 ist teilweise mit einer Füllmasse 11 gefüllt. Hierdurch kann die Strahlungsauskopplung aus dem Halbleiterchip 3 verbessert werden. Ferner kann mittels eines Luftspalts zwischen der Füllmasse 11 und dem Winkelfilterelement 6 ein vorteilhaft hoher Brechungsindexsprung am Übergang zum Winkelfilterelement erzielt werden.

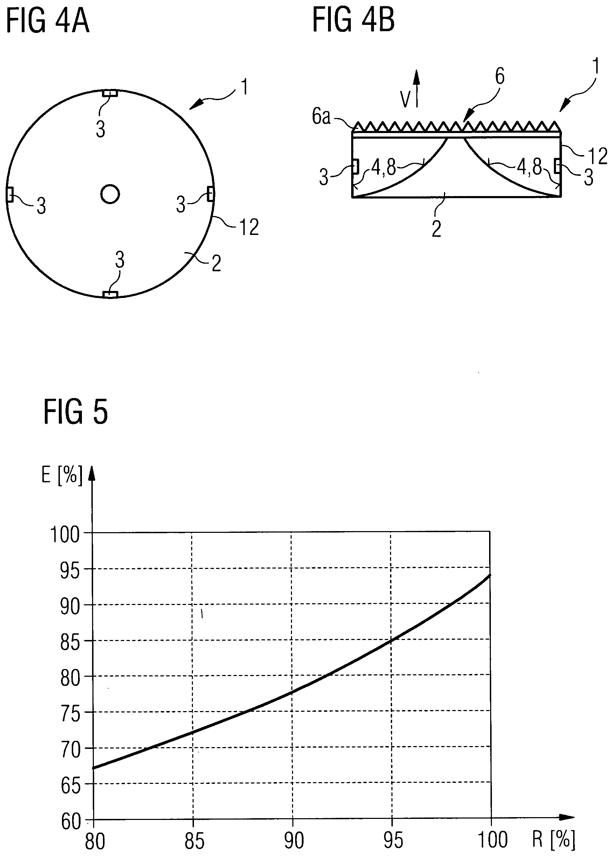

Die in den Figuren 4A und 4B dargestellte Beleuchtungsvorrichtung 1 weist ein Chipgehäuse 2 mit einem runden Grundriss und mehrere Strahlung emittierende Halbleiterchips 3 auf, die auf innen liegenden Seitenflächen 8 des Chipgehäuses 2 angeordnet sind.

Das Chipgehäuse 2 weist mehrere Vertiefungen 5 auf, die entlang einer Außenwand 12 der Beleuchtungsvorrichtung 1 angeordnet sind. Eine von einer derartigen Beleuchtungsvorrichtung 1 beleuchtete Fläche stellt einen Leuchtring dar.

Wie in der Querschnittsansicht der Figur 4B zu sehen ist, sind die den Halbleiterchips 3 gegenüber liegenden Seitenflächen 8 konkav gekrümmt. Hierdurch kann eine vorteilhafte Umlenkung der von den Halbleiterchips 3 erzeugten Strahlung in die Vorzugsrichtung V stattfinden.

Wenngleich die Vertiefungen 5 durch das Chipgehäuse 2 voneinander getrennt sind, so kann dennoch in der Strahlungsaustrittsebene mittels des Winkelfilterelements 6 eine Durchmischung der von den einzelnen Halbleiterchips 3 erzeugten Strahlung erzielt werden.

In dem Schaubild der Figur 5 ist die Extraktionseffizienz E einer Beleuchtungsvorrichtung gemäß der Erfindung über der Reflektivität R der reflektierenden Innenfläche aufgetragen.

Wie aus dem Schaubild hervorgeht, kann durch eine Erhöhung der Reflektivität R die Extraktionseffizienz E der Beleuchtungsvorrichtung gesteigert werden. Beispielsweise können bei einer Reflektivität R von 95% 85% der von dem Halbleiterchip beziehungsweise den Halbleiterchips erzeugten Strahlung aus der Beleuchtungsvorrichtung ausgekoppelt werden.

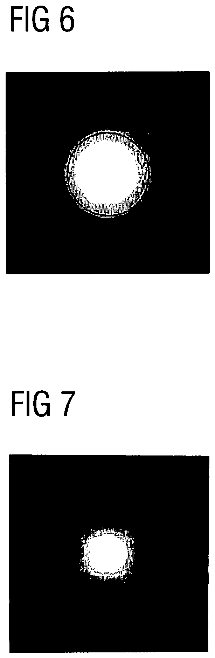

Figur 6 zeigt die Strahlungsintensitätsverteilung eines Lambertstrahlers in der Strahlungsaustrittsebene. Die schwarze Kreislinie kennzeichnet einen Abstrahlwinkel von 38°. Wie zu sehen ist, wird durch den Lambertstrahler die Kreisfläche innerhalb der schwarzen Kreislinie nahezu vollständig ausgeleuchtet.

Hingegen kann durch eine Beleuchtungsvorrichtung gemäß der Erfindung der Abstrahlwinkel derart eingeschränkt werden, dass wie in Figur 7 dargestellt nur ein innerer Teil der durch die schwarze Kreislinie begrenzten Kreisfläche ausgeleuchtet wird. In diesem inneren Teil tritt eine homogene Verteilung der Strahlungsintensität auf.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Beleuchtungsvorrichtung (1) aufweisend
- ein Chipgehäuse (2) mit mindestens einer Vertiefung (5), die durch eine reflektierende Innenfläche (4) begrenzt ist,
- mindestens einen Strahlung emittierenden Halbleiterchip (3) mit einer Chipfläche (9), der in der Vertiefung (5) angeordnet ist,
- ein chipfernes Winkelfilterelement (6), das in das Chipgehäuse (2) integriert ist und dem Halbleiterchip (3) in einer Vorzugsrichtung (V) nachgeordnet ist, wobei die reflektierende Innenfläche (4) mindestens zehnmal so groß ist wie die Chipfläche (9),
bei der die von dem Halbleiterchip (3) ausgesandte Strahlung auf das Winkelfilterelement (6) auftrifft und innerhalb eines ersten Einfallswinkelbereichs stärker reflektiert wird als innerhalb eines zweiten Einfallswinkelbereichs und der erste Einfallswinkelbereich kleinere Einfallswinkel umfasst als der zweite Einfallswinkelbereich.

2. Beleuchtungsvorrichtung (1) nach Anspruch 1, wobei die reflektierende Innenfläche (4) hundertmal größer ist als die Chipfläche (9).

3. Beleuchtungsvorrichtung (1) nach einem der vorhergehenden Ansprüche, wobei
die reflektierende Innenfläche (4) eine Reflektivität von 90% oder größer, bevorzugt von 95% oder größer, besonders bevorzugt von 98% oder größer, aufweist.

4. Beleuchtungsvorrichtung (1) nach einem der vorhergehenden Ansprüche, wobei
mittels des Winkelfilterelements (6) der Abstrahlwinkel der von der Beleuchtungsvorrichtung (1) ausgesandten Strahlung verkleinert wird.

5. Beleuchtungsvorrichtung (1) nach einem der vorhergehenden Ansprüche, wobei
die reflektierende Innenfläche (4) mindestens eine Seitenfläche (8) umfasst.

6. Beleuchtungsvorrichtung (1) nach Anspruch 5, wobei
die Seitenfläche (8) konkav gekrümmt ist.

7. Beleuchtungsvorrichtung (1) nach Anspruch 6, wobei
die Innenfläche (4) eine ebene Bodenfläche (7) sowie mehrere ebene Seitenflächen (8) aufweist, die schräg zu der Bodenfläche (7) verlaufen.

8. Beleuchtungsvorrichtung (1) nach einem der vorhergehenden Ansprüche, wobei
das Winkelfilterelement (6) eine Abdeckung für das Chipgehäuse (2) bildet.

9. Beleuchtungsvorrichtung (1) nach einem der vorhergehenden Ansprüche, wobei
das Winkelfilterelement (6) Strukturelemente (6a) aufweist, die kegelartig, pyramidenartig, prismenartig oder gleich inversen CPCs ausgebildet sind.

10. Beleuchtungsvorrichtung (1) nach Anspruch 9, wobei sich die Strukturelemente (6a) in Vorzugsrichtung (V) verjüngen.

11. Beleuchtungsvorrichtung (1) nach einem der Ansprüche 1 bis 8, wobei
das Winkelfilterelement (6) ein dielektrischer Filter ist.

12. Beleuchtungsvorrichtung (1) nach einem der vorhergehenden Ansprüche, wobei
die Vertiefung (5) teilweise mit einer Füllmasse (11) gefüllt ist.

13. Beleuchtungsvorrichtung (1) nach Anspruch 12, wobei zwischen der Füllmasse (11) und dem Winkelfilterelement (6) ein Luftspalt vorhanden ist.

## Claims

1. Lighting device (1) comprising
- a chip package (2) having at least one recess (5) delimited by a reflecting inner surface (4),
- at least one radiation emitting semiconductor chip (3) having a chip surface (9) arranged in the recess (5),
- an angle filter element (6) remote from the chip, which is integrated in the chip package (2) and is arranged downstream of the semiconductor chip (3) in a preferred direction (V),
wherein
the reflecting inner surface (4) is at least ten times as large as the chip surface (9),
in which the radiation emitted by the semiconductor chip (3) impinges on the angle filter element (6) and is more strongly reflected within a first range of an angle of incidence than within a second range of an angle of incidence and the first range of an angle of incidence comprises smaller angles of incidence than the second range of an angle of incidence.

2. Lighting device (1) according to claim 1, wherein
the reflecting inner surface (4) is a hundred times larger than the chip surface (9).

3. Lighting device (1) according to any of the preceding claims, wherein
the reflecting inner surface (4) has a reflectivity of 90% or greater, preferably of 95% or greater, especially preferably of 98% or greater.

4. Lighting device (1) according to any of the preceding claims, wherein
the angle filter element (6) is used to reduce the emission angle of radiation emitted by the lighting device (1).

5. Lighting device (1) according to any of the preceding claims, wherein
the reflecting inner surface (4) comprises at least one side surface (8).

6. Lighting device (1) according to claim 5, wherein
the side surface (8) is curved concave.

7. Lighting device (1) according to claim 6, wherein
the inner surface (4) comprises a flat bottom surface (7) and several flat side surfaces (8) which extend slanted to the bottom surface (7).

8. Lighting device (1) according to any of the preceding claims, wherein
the angle filter element (6) forms a cover for the chip package (2).

9. Lighting device (1) according to any of the preceding claims, wherein
the angle filter element (6) comprises structural elements (6a) which are conical, pyramidal, prismatic or equally inverse CPCs.

10. Lighting device (1) according to claim 9, wherein
the structural elements (6a) taper in the preferred direction (V) .

11. Lighting device (1) according to any one of claims 1 to 8, wherein
the angle filter element (6) is a dielectric filter.

12. Lighting device (1) according to any of the preceding claims, wherein
the recess (5) is partially filled with a filling compound (11) .

13. Lighting device (1) according to claim 12, wherein
there is an air gap between the filling compound (11) and the angle filter element (6).

## Revendications

1. Dispositif d'éclairage (1) comportant
- un boîtier de puce (2) présentant au moins une cavité (5) délimitée par une surface intérieure réfléchissante (4),
- au moins une puce à semi-conductrice émettant un rayonnement (3), présentant une surface de puce (9), logée dans la cavité (5),
- un élément de filtrage angulaire (6), éloignée de la puce, qui est intégré dans le boîtier de puce (2) et disposé en aval de la puce à semi- conductrice (3) dans une direction préférentielle (V), la surface intérieure réfléchissante (4) étant au moins dix fois plus grande que la surface de puce (9),
où le rayonnement émis par la puce à semi- conductrice (3) atteint l'élément de filtrage angulaire (6) et est reflété plus fortement dans une première plage d'angles d'incidence que dans une deuxième plage d'angles d'incidence, la première plage d'angles d'incidence comprenant des angles d'incidence plus petits que la deuxième plage d'angles d'incidence.

2. Dispositif d'éclairage (1) selon la revendication 1, la surface intérieure réfléchissante (4) étant cent fois plus grande que la surface de puce (9).

3. Dispositif d'éclairage (1) selon l'une quelconque des revendications précédentes,
la surface intérieure réfléchissante (4) présentant une réflectivité de 90 % ou plus, de préférence de 95 % ou plus, de préférence particulièrement de 98 % ou plus.

4. Dispositif d'éclairage (1) selon l'une quelconque des revendications précédentes,
l'angle de départ du rayonnement émis par le dispositif d'éclairage (1) étant réduit par l'intermédiaire de l'élément de filtrage angulaire (6).

5. Dispositif d'éclairage (1) selon l'une quelconque des revendications précédentes,
la surface intérieure réfléchissante (4) comportant au moins une surface latérale (8).

6. Dispositif d'éclairage (1) selon la revendication 5,
la surface latérale (8) présentant une courbure concave.

7. Dispositif d'éclairage (1) selon la revendication 6,
la surface intérieure réfléchissante (4) présentant une surface de fond planes (7) et plusieurs surfaces latérales planes (8) qui s'étendent en oblique par rapport à la face de surface de fond (7).

8. Dispositif d'éclairage (1) selon l'une quelconque des revendications précédentes,
l'élément de filtrage angulaire (6) formant une couverture pour le boîtier de puce (2).

9. Dispositif d'éclairage (1) selon l'une quelconque des revendications précédentes,
l'élément de filtrage angulaire (6) présentant des éléments de structure (6a) qui sont formés de manière conique, pyramidale, prismatique ou égale à des CPCs inverses.

10. Dispositif d'éclairage (1) selon la revendication 9,
les éléments de structure (6a) convergeant dans la direction préférentielle (V).

11. Dispositif d'éclairage (1) selon l'une quelconque des revendications 1 à 8,
l'élément de filtrage angulaire (6) étant un filtre diélectrique.

12. Dispositif d'éclairage (1) selon l'une quelconque des revendications précédentes,
la cavité (5) étant partiellement rempli d'une masse de remplissage (11).

13. Dispositif d'éclairage (1) selon la revendication 12,
un entrefer existant entre la masse de remplissage (11) et l'élément de filtrage angulaire (6).
